# EUROPÄISCHE PATENTSCHRIFT

(11) **EP 0 524 459 B1**
(45) Veröffentlichungstag und Bekanntmachung des Hinweises auf die Patenterteilung: **14.06.1995**
(21) Anmeldenummer: 92111168.8
(22) Anmeldetag: 01.07.1992
(51) Int. Cl.: H01S 3/103, H01S 3/19

(54) **Durchstimmbarer Halbleiterlaser auf semiisolierendem Substrat**
Tunable semiconductor laser on a semi-isolating substrate
Laser accordable à semi-conducteur sur un substrat semi-isolant

(30) Priorität: 26.07.1991 DE 4124874
(43) Veröffentlichungstag der Anmeldung: 27.01.1993
(73) Patentinhaber: SIEMENS AKTIENGESELLSCHAFT, 80333 München (DE)
(72) Erfinder: Amann, Markus-Christian, Dr.-Ing., W-8000 München 83 (DE); Illek, Stefan, Dr.rer.nat., W-8152 Feldkirchen-Westerham (DE); Thulke, Wolfgang, Dr.rer.nat., W-8000 München 83 (DE)

(56) Entgegenhaltungen:
- EP-A- 0 404 551
- EP-A- 0 487 876
- lEE PROCEEDINGS-J Bd. 137, Nr. 1, Februar 1990, STEVENAGE, GB Seiten 69 - 73, XP000095896;C.F.J. SCHANEN ET AL. 'Fabrication and Lasing Characteristics of lambda= 1.56 um tunable twin-guide (TTG) DFB Lasers'
- PATENT ABSTRACTS OF JAPAN vol. 15, no. 295 (E-1094)26. Juli 1991 & JP-A-31 05 991
- PATENT ABSTRACTS OF JAPAN vol. 7, no. 13 (E-153)19. Januar 1982 & JP-A-57 172 790
- PATENT ABSTRACTS OF JAPAN vol. 13, no. 346 (E-798)(3694) 3. August 1989 & JP-A-11 03 890

## Beschreibung

Die vorliegende Erfindung betrifft einen Halbleiterlaser auf semiisolierendem Substrat, insbesondere einen durchstimmbaren Halbleiterlaser mit übereinander angeordneter aktiver Schicht und Abstimmschicht.

Für zahlreiche Anwendungen von Halbleiterlasern ist es erforderlich, die Wellenlänge des emittierten Lichtes möglichst schnell und stetig zu verändern. Ein Beispiel dafür ist der optische Überlagerungsempfang, bei dem der Halbleiterlaser als Lokaloszillator im Empfänger zur Demodulation des Signals dient. In der europäischen Patentanmeldung EP 0 360 011 ist ein abstimmbarer DFB-Laser beschrieben, bei dem eine aktive Schicht und eine Abstimmschicht vertikal zueinander angeordnet sind und eine getrennte Strominjektion über eine dazwischen angeordnete Zwischenschicht und Seitenbereiche möglich ist. Diese Laserdiode ist wegen ihrer weiten, stufenlosen Durchstimmbarkeit für den vorgenannten Zweck besonders geeignet (TTG-DFB-Laserdiode).

In ihren bisher realisierten Ausführungformen wird diese Laserdiode auf einem p-dotierten Substrat hergestellt, das die elektrische Zuleitung zur aktiven Schicht oder zur Abstimmschicht, je nachdem welche dieser Schichten auf der dem Substrat zugewandten Seite der Zwischenschicht angeordnet ist, darstellt. Das Substrat kann dabei nicht mit der gemeinsamen elektrischen Masse der weiteren Komponenten verbunden werden, sondern muß gegen den gemeinsamen Subträger elektrisch isoliert werden. Eine einfach herstellbare und mechanisch stabilere TTG-DFB-Laserdiode direkt auf einem elektrisch isolierenden Substrat ist in der unter Art. 54 (3) EPÜ fallenden EP 0 487 876 A3 beschrieben. Die dafür erforderliche Bauform der Laserdiode, deren elektrische Kontakte bei semiisolierendem Substrat alle auf einer Seite der Laserschichten liegen müssen, ist auch durch einen monolithisch integrierten passiven optischen Wellenleiter bestimmt. Die Anordnung der drei erforderlichen Kontakte wird bei der Laserdiode dieser Patentanmeldung dadurch erleichtert, daß über dem integrierten Wellenleiter ausreichend Platz für die Bondfläche zumindest eines Kontaktes ist. Ein Nachteil dieser Anordnung ist die unebene Oberfläche der Laserdiode, die Stufen von mehreren Mikrometern Höhe aufweist. Sie erschwert die Herstellung der Kontakte und verringert die mechanische Stabilität dieser Anordnung. Der passive Wellenleiter, der einerseits die ausreichenden Bondflächen ermöglicht, ist nur bei der monolithischen Integration der Laserdiode von Nutzen.

Aufgabe der vorliegenden Erfindung ist es, eine einfach herstellbare TTG-DFB-Laserdiode auf semiisolierendem Substrat, insbesondere als Einzelbaustein anzugeben.

Diese Aufgabe wird mit den Laserdioden mit den Merkmalen der Ansprüche 1, 2 und 3 gelöst. Weitere Ausgestaltungen ergeben sich aus den abhängigen Ansprüchen.

Es folgt eine Beschreibung der erfindungsgemäßen Laserdiode anhand der Figuren 1 bis 3.
- Fig. 1 und 2: zeigen Ausführungsbeispiele der erfindungsgemäßen Laserdiode im Querschnitt.
- Fig. 3: zeigt das Ausführungsbeispiel von Fig. 2 in Aufsicht.

Bei der erfindungsgemäßen Laserdiode ist die streifenförmige Schichtstruktur, die die aktive Schicht und die Abstimmschicht mit der dazwischen angeordneten Zwischenschicht umfaßt, mit einer Mantelschicht überwachsen, deren auf der streifenförmigen Schichtstruktur vorhandener Anteil entgegengesetzt zu dem Rest dieser Mantelschicht dotiert ist, so daß durch einen seitlich aufgebrachten Kontakt und einen streifenförmigen längs der Schichtstruktur verlaufenden Kontakt eine gesonderte Strominjektion in die oberhalb der Zwischenschicht angeordnete Schicht erfolgen kann. Die Strominjektion in die auf der dem Substrat zugewandten Seite der Zwischenschicht angeordnete Schicht erfolgt durch einen weiteren, seitlich angeordneten Kontakt auf einem ebenfalls gegenüber dem restlichen Material der Mantelschicht umgekehrt dotierten Bereich, der eine Verlängerung z. B. durch eine Pufferschicht oder einen oberen Schichtanteil des Substrates bis hin zu der dem Substrat zugewandten Seite der streifenförmigen Schichtstruktur besitzt. Die nachstehend beschriebenen Ausführungsformen geben zwei Lösungen an, wie die Kontakte mit ausreichend großen Bondflächen versehen werden können. Dadurch ist das Problem gelöst, eine Laserdiode auf semiisolierendem Substrat mit zwei vertikal zueinander angeordneten, getrennt ansteuerbaren Schichten anzugeben, die einen im wesentlichen planaren Aufbau besitzt.

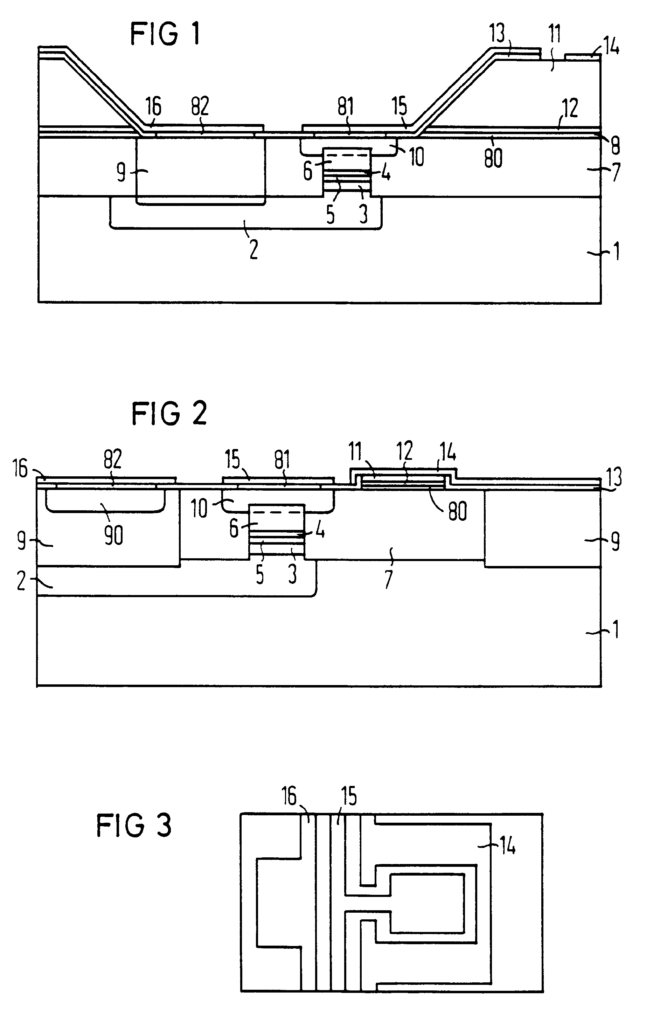

In Fig. 1 ist auf einem Substrat 1 aus semiisolierendem Material eine streifenförmige Schichtstruktur, die seitlich und oberhalb von einer Mantelschicht 7 umschlossen wird, aufgebracht. Die Schichtstruktur umfaßt eine aktive Schicht 3, eine Zwischenschicht 5, eine Abstimmschicht 4 und eine weitere Mantelschicht 6. Die Abstimmschicht 4 kann auch auf der dem Substrat zugewandten Seite der Zwischenschicht und die aktive Schicht 3 auf der dem Substrat abgewandten Seite der Zwischenschicht 5 angeordnet sein. Statt der Abstimmschicht kann auch eine zweite aktive Schicht vorgesehen sein. Die Zwischenschicht 5 und die Mantelschicht 7 sind für einen ersten Leitungstyp (z. B. n-Leitung) dotiert. Die weitere Mantelschicht 6, die auch ein Bestandteil der Mantelschicht 7 sein kann, ist für entgegengesetzten Leitungstyp (z. B. p-Leitung) dotiert. Die weitere Mantelschicht 6, die den oberen Anteil der streifenförmigen Schichtstruktur bildet, dient einer scharfen Begrenzung des in der Mantelschicht 7 ausgebildeten dotierten oberen Bereiches 10, der für den zweiten Leitfähigkeitstyp (p-Leitung) dotiert ist. Dieser obere Bereich 10 kann z. B. durch Implantation oder Diffusion in den oberen Anteil der niedrig dotierten Mantelschicht 7 hergestellt werden. Auf einer Seite der Schichtstruktur ist ein lateraler Bereich 9, der ebenfalls für den zweiten Leitfähigkeitstyp umdotiert ist, in der Mantelschicht 7 ausgebildet. Über einen unteren Bereich 2 ist dieser laterale Bereich 9 elektrisch mit der untersten Schicht (aktive Schicht 3) der Schichtstruktur verbunden. Dieser untere Bereich 2 kann wie in Fig. 1 dargestellt in dem Substrat 1 oder in einer auf das Substrat aufgebrachten Pufferschicht ausgebildet sein. Auf der im wesentlichen planaren Oberfläche der Mantelschicht 7 ist eine Kontaktschicht 8 aufgebracht, die einen ersten Anteil 80 auf einem für den ersten Leitfähigkeitstyp dotierten Anteil der Mantelschicht 7, einen zweiten Anteil 81 auf dem oberen Bereich 10 und einen dritten Anteil 82 auf dem lateralen Bereich 9 besitzt. Diese Anteile 80, 81, 82 der Kontaktschicht 8 sind voneinander elektrisch isoliert (z. B. durch die Oxidschicht 13). Um eine ausreichende Breite eines auf den auf den oberen Bereich 10 befindlichen Anteil 81 der Kontaktschicht 8 aufgebrachten Kontaktes 15 zu ermöglichen, ist eine weitere Kontaktschicht 11 für einen lateralen Kontakt 14 vorhanden. Diese weitere Kontaktschicht 11 ist ausreichend hoch dotiert, so daß diese Kontaktschicht 11 eine ausreichend hohe Leitfähigkeit aufweist und den großen Abstand des seitlich aufgebrachten Kontaktes von der streifenförmigen Schichtstruktur kompensiert. Der mittlere Kontakt 15 kann daher ausreichend breit und mit ausreichend großen Bondflächen ausgebildet sein. Zwischen der Kontaktschicht 8 und der weiteren Kontaktschicht 11 befindet sich eine Ätzstoppschicht 12. Eine Oxidschicht 13 dient der Isolation von jeweils elektrisch voneinander getrennten Anteilen der Kontaktschicht 8. Der Vorteil dieser Ausführungsform besteht in der einfachen Form der Kontaktmetallisierungen. Sie können als breite, über die gesamte Länge der Laserstruktur reichende Streifen ausgebildet werden, die genügend Platz für Bondanschlüsse bieten.

Bei der Ausführungsform der Fig. 2 ist die weitere Kontaktschicht 11 dünn und besitzt wie der darunter befindliche Anteil 83 der Kontaktschicht die Form eines schmalen Streifens. Die Anteile der Kontaktschicht auf einem höher dotierten oberen Anteil 90 des lateralen Bereiches 9 und auf dem oberen Bereich 10 sind ebenfalls streifenförmig. Eine Ätzstoppschicht 12 zwischen der weiteren Kontaktschicht 11 und dem Anteil 80 der Kontaktschicht ist ebenfalls streifenförmig. Der elektrische Anschluß der untersten Schicht (aktive Schicht 3 in diesem Ausführungsbeispiel) über den lateralen Bereich 9 und den unteren Bereich 2 kann hierbei außer durch Diffusion oder Implantation von Dotierstoff auch durch eine epitaktisch gewachsene p-dotierte Halbleiterschicht realisiert werden.

Die Kontaktmetallisierungen (Kontakte 14, 15, 16) können bei dieser Ausführungsform nicht mehr die Form breiter Streifen besitzen, da die Leitfähigkeit der dünnen weiteren Kontaktschicht 11 zu gering ist, große Distanzen zu überbrücken. Eine mögliche Form der Kontaktmetallisierung für diese Ausführungsform ist in Fig. 3 in Aufsicht dargestellt. Einer der seitlich aufgebrachten Kontakte 14 ist omegaförmig. Der über dem betreffenden Anteil der Kontaktschicht 8 befindliche streifenförmige Anteil dieses Kontaktes 14 ist in der Länge unterbrochen, um eine Verbindung des mittleren Kontaktes 15, der über dem oberen Bereich 10 aufgebracht ist, mit einer ausreichend großen Bondfläche in dem von dem omegaförmigen Kontakt 14 freigelassenen Bereich zu ermöglichen.

Die erfindungsgemäße Laserdiode wird hergestellt, indem in dem Substrat 1 oder einer darauf aufgewachsenen Halbleiterschicht ein lokal begrenztes p-leitendes Gebiet, das für den unteren Bereich 2 vorgesehen ist, im Bereich des später zu definierenden Laserstreifens durch Diffusion oder Implantation von Dotierstoff hergestellt wird. Anschließend werden die Schichten der Laser-Grundstruktur epitaktisch ganzflächig abgeschieden. Diese Schichten enthalten eine aktive Schicht 3 und eine Abstimmschicht 4, die durch eine dünne n-leitende Zwischenschicht 5 voneinander getrennt sind. Die aktive Schicht kann über oder unter der Zwischenschicht angeordnet sein. Diese Schichtenfolge wird durch eine p-leitende obere Mantelschicht 6 nach oben abgeschlossen.

Diese Schichten werden auf photolithographischem Weg auf einen schmalen Steg rückgeätzt, der anschließend mit der n-leitenden Mantelschicht 7 überwachsen wird. Die Höhe der Dotierungsdichte dieser Schicht ist so gering, daß sie eine spätere lokale Umdotierung in einen p-Leitungstyp durch Diffusion oder Implantation zur Herstellung des oberen Bereiches 10 und des lateralen Bereiches 9 erlaubt. Entsprechend den beiden beschriebenen Ausführungsformen werden die Kontaktschicht 8 und die weitere Kontaktschicht 11 aufgewachsen und strukturiert. Die Oxidschicht 13 wird für die elektrische Isolation aufgebracht und anschließend die Kontakte 14, 15, 16 aufgebracht. Die Kontaktschicht 8 ist zunächst niedrig n-leitend dotiert. Der obere Bereich 10 wird nach dem Aufbringen dieser Kontaktschicht 8 durch Diffusion oder Implantation von Dotierstoff hergestellt, wobei der betreffende Anteil 81 der Kontaktschicht 8 in eine gut p-leitende Schicht umdotiert wird. Die Diffusion bzw. Implantation wird soweit vorgenommen, daß der obere Bereich 10 mindestens bis an die weitere Mantelschicht 6 heranreicht. Die weitere Mantelschicht bewirkt eine scharfe Begrenzung des p-leitend dotierten Bereiches zu der nachfolgenden Schicht (Abstimmschicht 4) der Laser-Schichtstruktur. Die weitere Mantelschicht 6 kann daher als zu dem oberen Bereich 10 gehörender Anteil der Mantelschicht 7 gerechnet werden. Wegen der niedrigen Dotierungshöhe der Kontaktschicht 8 im n-leitenden Bereich der Mantelschicht 7 ist in beiden Ausführungformen eine weitere Kontaktschicht 11 in diesem Bereich aufgebracht. Diese weitere Kontaktschicht 11 ist in beiden Ausführungsformen hoch n-leitend dotiert.

Die erfindungsgemäße Laserdiode ermöglicht es, bei einem praktisch planaren Aufbau alle Kontakte mit ausreichend großen Bondflächen auf der überwachsenen Oberfläche des Bauelementes anzuordnen.

## Patentansprüche

1. Laserdiode auf semiisolierendem Substrat (1) mit einer steifenförmigen Schichtstruktur, die eine Zwischenschicht (5) zwischen zwei speziellen Schichten (3, 4), von denen mindestens eine Schicht eine für Strahlungserzeugung vorgesehene aktive Schicht (3) ist, umfaßt,
bei der eine an diese Schichtstruktur beidseitig lateral angrenzende Mantelschicht (7), die im wesentlichen für elektrische Leitung eines ersten Leitfähigkeitstyps dotiert ist, vorhanden ist,
bei der ein oberer Bereich (10), der für einen entgegengesetzten, zweiten Leitungstyp dotiert ist, über der Schichtstruktur und ein davon getrennter lateraler Bereich (9), der für diesen zweiten Leitungstyp dotiert ist und der mit der dem Substrat (1) zugewandten Seite der Schichtstruktur elektrisch leitend verbunden ist, ausgebildet sind,
bei der eine Kontaktschicht (8) mit elektrisch voneinander getrennten Anteilen (80, 81, 82) auf diesem oberen Bereich (10), diesem lateralen Bereich (9) und einem für den ersten Leitungstyp dotierten Bereich der Mantelschicht (7) vorhanden ist und bei der elektrisch voneinander getrennte Kontakte (14, 15, 16) für diese Anteile (80, 81, 82) der Kontaktschicht (8) vorhanden sind, so daß eine getrennte Strominjektion durch die Zwischenschicht (5) in jede der speziellen Schichten (3, 4) möglich ist, und
bei der der Kontakt (14), der für den auf einem für den ersten Leitungstyp dotierten Bereich der Mantelschicht (7) aufgebrachten Anteil (80) der Kontaktschicht (8) vorgesehen ist, auf einer hoch für den ersten Leitungstyp dotierten weiteren Kontaktschicht (11) aufgebracht ist.

2. Laserdiode auf semiisolierendem Substrat (1) mit einer steifenförmigen Schichtstruktur, die eine Zwischenschicht (5) zwischen zwei speziellen Schichten (3, 4), von denen mindestens eine eine für Strahlungserzeugung vorgesehene aktive Schicht (3) ist, umfaßt,
bei der eine an diese Schichtstruktur beidseitig lateral angrenzende Mantelschicht (7), die im wesentlichen für elektrische Leitung eines ersten Leitfähigkeitstyps dotiert ist, vorhanden ist,
bei der ein oberer Bereich (10), der für einen entgegengesetzten, zweiten Leitungstyp dotiert ist, über der Schichtstruktur und ein davon getrennter lateraler Bereich (9), der für diesen zweiten Leitungstyp dotiert ist und der mit der dem Substrat (1) zugewandten Seite der Schichtstruktur elektrisch leitend verbunden ist, ausgebildet sind,
bei der eine Kontaktschicht (8) mit elektrisch voneinander getrennten Anteilen (80, 81, 82) auf diesem oberen Bereich (10), diesem lateralen Bereich (9) und einem für den ersten Leitungstyp dotierten Bereich der Mantelschicht (7) vorhanden ist und bei der elektrisch voneinander getrennte Kontakte (14, 15, 16) für diese Anteile (80, 81, 82) der Kontaktschicht (8) vorhanden sind, so daß eine getrennte Strominjektion durch die Zwischenschicht (5) in jede der speziellen Schichten (3, 4) möglich ist,
bei der ein für einen nicht auf dem oberen Bereich (10) angeordneter Anteil (80, 82) der Kontaktschicht (8) vorgesehener Kontakt (14) eine in Aufsicht omegaförmige Anordnung aufweist, die einen für eine Bondfläche des für den auf dem oberen Bereich (10) angeordneten Anteil (81) der Kontaktschicht (8) vorgesehenen Kontaktes (15) vorgesehenen Bereich freiläßt.

3. Laserdiode auf semiisolierendem Substrat (1) mit einer steifenförmigen Schichtstruktur, die eine Zwischenschicht (5) zwischen zwei speziellen Schichten (3, 4), von denen mindestens eine eine für Strahlungserzeugung vorgesehene aktive Schicht (3) ist, umfaßt,
bei der eine an diese Schichtstruktur beidseitig lateral angrenzende Mantelschicht (7), die im wesentlichen für elektrische Leitung eines ersten Leitfähigkeitstyps dotiert ist, vorhanden ist,
bei der ein oberer Bereich (10), der für einen entgegengesetzten, zweiten Leitungstyp dotiert ist, über der Schichtstruktur und ein davon getrennter lateraler Bereich (9), der für diesen zweiten Leitungstyp dotiert ist und der mit der dem Substrat (1) zugewandten Seite der Schichtstruktur elektrisch leitend verbunden ist, ausgebildet sind,
bei der eine Kontaktschicht (8) mit elektrisch voneinander getrennten Anteilen (80, 81, 82) auf diesem oberen Bereich (10), diesem lateralen Bereich (9) und einem für den ersten Leitungstyp dotierten Bereich der Mantelschicht (7) vorhanden ist und bei der elektrisch voneinander getrennte Kontakte (14, 15, 16) für diese Anteile (80, 81, 82) der Kontaktschicht (8) vorhanden sind, so daß eine getrennte Strominjektion durch die Zwischenschicht (5) in jede der speziellen Schichten (3, 4) möglich ist,
bei der die auf der dem Substrat (1) abgewandten Seite der Zwischenschicht (5) befindliche spezielle Schicht (4) eine Abstimmschicht ist.

4. Laserdiode nach Anspruch 1,
bei der ein für einen nicht auf dem oberen Bereich (10) angeordneter Anteil (80, 82) der Kontaktschicht (8) vorgesehener Kontakt (14) eine in Aufsicht omegaförmige Anordnung aufweist, die einen für eine Bondfläche des für den auf dem oberen Bereich (10) angeordneten Anteil (81) der Kontaktschicht (8) vorgesehenen Kontaktes (15) vorgesehenen Bereich freiläßt.

5. Laserdiode nach Anspruch 1 oder 2,
bei der die auf der dem Substrat (1) abgewandten Seite der Zwischenschicht (5) befindliche spezielle Schicht (4) eine Abstimmschicht ist.

6. Laserdiode nach einem der vorhergehenden Ansprüche,
bei der ein für den zweiten Leitungstyp dotierter unterer Bereich (2) in dem Substrat (1) ausgebildet ist, der den lateralen Bereich (9) mit der dem Substrat (1) zugewandten Seite der Schichtstruktur elektrisch verbindet.

7. Laserdiode nach einem der Ansprüche 1, 2, 4 oder 6,
bei der eine der speziellen Schichten eine für eine Wellenlängenänderung vorgesehene Abstimmschicht (4) ist.

8. Laserdiode nach einem der Ansprüche 1, 2 oder 4 oder einem dieser Ansprüche und Anspruch 6 oder 7,
bei der die auf der dem Substrat (1) zugewandten Seite der Zwischenschicht (5) befindliche spezielle Schicht (4) eine Abstimmschicht ist.

## Claims

1. Laser diode on a semi-insulating substrate (1) having a stripe-shaped layer structure which comprises an intermediate layer (5) between two special layers (3, 4), of which at least one layer is an active layer (3) provided for generating radiation,
in which there is present a covering layer (7) which laterally adjoins this layer structure on both sides and is essentially doped for electric conduction of a first conductivity type,
in which an upper region (10) which is doped for an opposite, second conductivity type is constructed over the layer structure and a lateral region (9), separated therefrom, is constructed which is doped for this second conductivity type and which is connected in an electrically conductive fashion to the side of the layer structure facing the substrate (1),
in which a contact layer (8) having electrically mutually separated portions (80, 81, 82) is present on this upper region (10), this lateral region (9) and a region of the covering layer (7) which is doped for the first conductivity type, and in which electrically mutually separated contacts (14, 15, 16) are present for these portions (80, 81, 82) of the contact layer (8), with the result that a separate current injection into each of the special layers (3, 4) is possible through the intermediate layer (5), and
in which the contact (14), which is provided for the portion (80) of the contact layer (8) which is applied on a region of the contact layer (7) which is doped for the first conductivity type, is applied on a further contact layer (11) which is highly doped for the first conductivity type.

2. Laser diode on a semi-insulating substrate (1) having a stripe-shaped layer structure which comprises an intermediate layer (5) between two special layers (3, 4), of which at least one layer is an active layer (3) provided for generating radiation,
in which there is present a covering layer (7) which laterally adjoins this layer structure on both sides and is essentially doped for electric conduction of a first conductivity type,
in which an upper region (10) which is doped for an opposite, second conductivity type is constructed over the layer structure and a lateral region (9), separated therefrom, is constructed which is doped for this second conductivity type and which is connected in an electrically conductive fashion to the side of the layer structure facing the substrate (1),
in which a contact layer (8) having electrically mutually separated portions (80, 81, 82) is present on this upper region (10), this lateral region (9) and a region of the covering layer (7) which is doped for the first conductivity type, and in which electrically mutually separated contacts (14, 15, 16) are present for these portions (80, 81, 82) of the contact layer (8), with the result that a separate current injection into each of the special layers (3, 4) is possible through the intermediate layer (5), and
in which a contact (14) provided for a portion (80, 82) of the contact layer (8) which is not arranged on the upper region (10) has an arrangement which is omega-shaped in plan view and leaves free a region provided for a bonding area of the contact (15) provided for the portion (81) of the contact layer (8) which is arranged on the upper region (10).

3. Laser diode on a semi-insulating substrate (1) having a stripe-shaped layer structure which comprises an intermediate layer (5) between two special layers (3, 4), of which at least one layer is an active layer (3) provided for generating radiation,
in which there is present a covering layer (7) which laterally adjoins this layer structure on both sides and is essentially doped for electric conduction of a first conductivity type,
in which an upper region (10) which is doped for an opposite, second conductivity type is constructed over the layer structure and a lateral region (9), separated therefrom, is constructed which is doped for this second conductivity type and which is connected in an electrically conductive fashion to the side of the layer structure facing the substrate (1),
in which a contact layer (8) having electrically mutually separated portions (80, 81, 82) is present on this upper region (10), this lateral region (9) and a region of the covering layer (7) which is doped for the first conductivity type, and in which electrically mutually separated contacts (14, 15, 16) are present for these portions (80, 81, 82) of the contact layer (8), with the result that a separate current injection into each of the special layers (3, 4) is possible through the intermediate layer (5), and
in which the special layer (4) located on the side of the intermediate layer (5) which is averted from the substrate (1) is a tuning layer.

4. Laser diode according to Claim 1, in which a contact (14) provided for a portion (80, 82) of the contact layer (8) which is not arranged on the upper region (10) has an arrangement which is omega-shaped in plan view and leaves free a region provided for a bonding area of the contact (15) provided for the portion (81) of the contact layer (8) which is arranged on the upper region (10).

5. Laser diode according to Claim 1 or 2, in which the special layer (4) located on the side of the intermediate layer (5) which is averted from the substrate (1) is a tuning layer.

6. Laser diode according to one of the preceding claims, in which there is constructed in the substrate (1) a lower region (2) which is doped for the second conductivity type and electrically connects the lateral region (9) to the side of the layer structure facing the substrate (1).

7. Laser diode according to one of Claims 1, 2, 4 or 6, in which one of the special layers is a tuning layer (4) provided for a change in wavelength.

8. Laser diode according to one of Claims 1, 2 or 4 or one of these claims and Claim 6 or 7, in which the special layer (4) located on the side of the intermediate layer (5) which is facing the substrate (1) is a tuning layer.

## Revendications

1. Diode laser disposée sur un substrat semi-isolant (1) comportant une structure à couches en forme de bande, qui comprend une couche intermédiaire (5) située entre deux couches particulières (3,4), dont l'une au moins est une couche active (3) prévue pour la production d'un rayonnement, et dans laquelle
il est prévu une couche enveloppe (7), qui jouxte latéralement et des deux côtés cette structure à couches et est dopée essentiellement pour fournir une conduction électrique d'un premier type de conductivité,
il est prévu une région supérieure (10), qui est dopée de manière à produire un second type de conductivité opposé et est disposée au-dessus de la structure à couches, et une couche latérale (9), qui est séparée de la précédente et est dopée de manière à présenter ce second type de conductivité et qui est reliée d'une manière électriquement conductrice à la face de la structure à couches, qui est tournée vers le substrat (1),
il est prévu une couche de contact (8) comportant des parties (80, 81, 82) séparées électriquement les unes des autres, sur cette région supérieure (10), sur cette région latérale (9) et sur une région, dopée de manière à présenter le premier type de conductivité, de la couche enveloppe (7), et il est prévu des contacts (14,15,16) séparés électriquement les uns des autres, pour ces parties (80, 81, 82) de la couche de contact (8), de sorte qu'une injection de courant séparée à travers la couche intermédiaire (5) dans chacune des couches particulières (3,4), est possible, et
le contact (14), qui est prévu pour la partie (80) de la couche de contact (8), qui est déposée sur une région dopée de manière à présenter le premier type de conductivité, de la couche enveloppe (7), est déposé sur une autre couche de contact (11) fortement dopée de manière à présenter le premier type de conductivité.

2. Diode laser déposée sur un substrat semi-isolant (1), comportant une structure à couches en forme de bande, qui comprend une couche intermédiaire (5) située entre deux couches particulières (3,4), dont l'une au moins est une couche active (3) prévue pour la production d'un rayonnement, et dans laquelle
il est prévu une couche enveloppe (7), qui jouxte latéralement et des deux côtés cette structure à couches et est dopée essentiellement pour fournir une conduction électrique d'un premier type de conductivité,
il est prévu une région supérieure (10), qui est dopée de manière à produire un second type de conductivité opposé et est disposée au-dessus de la structure à couches, et une couche latérale (9), qui est séparée de la précédente et est dopée de manière à présenter ce second type de conductivité et qui est reliée d'une manière électriquement conductrice à la face de la structure à couches, qui est tournée vers le substrat (1),
il est prévu une couche de contact (8) comportant des parties (80, 81, 82) séparées électriquement les unes des autres, sur cette région supérieure (10), sur cette région latérale (9) et sur une région, dopée de manière à présenter le premier type de conductivité, de la couche enveloppe (7), et il est prévu des contacts (14,15,16) séparés électriquement les uns des autres, pour ces parties (80, 81, 82) de la couche de contact (8), de sorte qu'une injection de courant séparée à travers la couche irtermédiaire (5) dans chacune des couches particulières (3,4), est possible, et
un contact (14), prévu pour une partie (80, 82) de la couche de contact (8), qui n'est pas disposée sur la région supérieure (10), possède un dispositif en forme de omega en vue en plan, qui laisse dégagée une région prévue pour une surface de liaison du contact (15) qui est prévu pour la partie (81), déposée sur la région supérieure (10), de la couche de contact (8).

3. Diode laser déposée sur un substrat semi-isolant (1), comportant une structure à couches en forme de bande, qui comprend une couche intermédiaire (5) située entre deux couches particulières (3,4), dont l'une au moins est une couche active (3) prévue pour la production d'un rayonnement, et dans laquelle
il est prévu une couche enveloppe (7), qui jouxte latéralement et des deux côtés cette structure à couches et est dopée essentiellement pour fournir une conduction électrique d'un premier type de conductivité,
il est prévu une région supérieure (10), qui est dopée de manière à produire un second type de conductivité opposé et est disposée au-dessus de la structure à couches, et une couche latérale (9), qui est séparée de la précédente et est dopée de manière à présenter ce second type de conductivité et qui est reliée d'une manière électriquement conductrice à la face de la structure à couches, qui est tournée vers le substrat (1),
il est prévu une couche de contact (8) comportant des parties (80, 81, 82) séparées électriquement les unes des autres, sur cette région supérieure (10), sur cette région latérale (9) et sur une région, dopée de manière à présenter le premier type de conductivité, de la couche enveloppe (7), et il est prévu des contacts (14,15,16) séparés électriquement les uns des autres, pour ces parties (80, 81, 82) de la couche de contact (8), de sorte qu'une injection séparée de courant à travers la couche intermédiaire (5) dans chacune des couches particulières (3,4), est possible, et
la couche particulière (4), qui est située sur la face de la couche intermédiaire (5), tournée à l'opposé du substrat (1), est une couche de réglage d'accord.

4. Diode laser suivant la revendication 1, dans laquelle un contact (14), prévu pour une partie (80, 82) de la couche de contact (8), qui n'est pas disposée sur la région supérieure (10), possède un dispositif en forme de omega en vue en plan, qui laisse dégagée une région prévue pour une surface de liaison du contact (15) qui est prévu pour la partie (81), déposée sur la région supérieure (10), de la couche de contact (8).

5. Diode laser suivant la revendication 1 ou 2, caractérisée par le fait que la couche particulière (4), qui est située sur la face de la couche intermédiaire (5), tournée à l'opposé du substrat (1), est une couche de réglage d'accord.

6. Diode laser suivant l'une quelconque des revendications précédentes, dans laquelle dans le substrat (1) est formée une région inférieure (2) dopée de manière à présenter le second type de conductivité et qui relie électriquement la région latérale (9) à la face de la structure à couches, tournée vers le substrat (1).

7. Diode laser suivant l'une des revendications 1, 2, 4 ou 6, dans laquelle l'une des couches particulières est une couche de réglage d'accord (4) prévue pour modifier la longueur d'onde.

8. Diode laser suivant l'une des revendications 1, 2 ou 4 ou l'une de ces revendications et la revendication 6 ou 7, dans laquelle la couche particulière (4), située sur la face de la couche intermédiaire (5) tournée à l'opposé du substrat (1), est une couche de réglage d'accord.
